# EUROPÄISCHE PATENTANMELDUNG

(11) **EP 1 850 379 A1**
(43) Veröffentlichungstag der Anmeldung: **31.10.2007**
(21) Anmeldenummer: 06023843.3
(22) Anmeldetag: 16.11.2006
(51) Int. Cl.: H01L 23/36, B23K 35/26

(54) **Wärmeleitschicht und Verfahren zu deren Herstellung**

(30) Priorität: 29.04.2006 DE 102006020584
(71) Anmelder: Metzke, Michael, 39179 Ebendorf (DE)
(72) Erfinder: Metzke, Michael, 39179 Ebendorf (DE); Heyer, Stefan, 39120 Magdeburg (DE)
(74) Vertreter: Kagelmann, Manfred

(57) **Zusammenfassung**

Die Erfindung betrifft einen Stoff und ein Verfahren zur Herstellung einer haftenden Wärmeleitschicht aus Metall und Metall-Kohlenstoff-Gemischen und Metallgut wärmeleitenden Nichtmetall- Gemischen, insbesondere zur Verwendung in der Elektro- und Elektronikindustrie.

Erfindungsgemäß besteht der Stoff aus welchem die Wärmeleitschicht zur Anordnung zwischen elektrischen und/oder elektronischen Bauelementen und/oder Baugruppen einerseits und Kühlkörpern und/oder Kühlelementen andererseits, besteht, ist ein Metallgemisch bzw. eine Legierung aus 10 bis 90 Gewichtsanteilen Indium und 10 bis 90 Gewichtsanteilen anderer geeigneter Metalle, die als Legierung oder im Gemisch einen Schmelzpunkt von etwa 50 bis 100 °C aufweisen. Solche Legierungs- bzw. Gemischbestandteile sind z.B. Metalle wie Zinn und/oder Wismut unter Ausschluss von solchen Metallen die der Gefahrstoffverordnung unterliegen, wie z.B. Gallium, Cadmium, Blei, Quecksilber usw.. Der erfindungsgemäße Stoff zur Herstellung der Wärmeleitschicht kann auch noch weitere Zusätze von gut wärmeleitfähigen Metallen wie z.B. Kupfer und/oder Silber und/oder nichtmetallische Stoffe wie z.B. Kohlenstoff in Form von Graphit enthalten.

Die Vorzüge der Erfindung bestehen darin, dass die mittels des erfindungsgemäßen Stoffes hergestellten Wärmeleitschichten ausschließlich aus sehr gut wärmeleitenden Materialien wie Metalle und Kohlenstoff als Schmelze auf die zu beschichtenden Flächen aufgetragen werden, womit isolierende Lufteinschlüsse absolut vermieden werden.

Durch die verschiedenen Konfektionierungen als Paste, Folie oder Barren für eine Schmelze ist der technologische Prozess für die Anwendung der Erfindung sehr variabel.

Auch der erfindungsgemäße Stoff selbst lässt sich durch die Auswahl seiner Legierungsbestandteile genau definiert den erforderlichen und gewünschten unterschiedlichen Schmelztemperaturen für unterschiedliche Anwendungszwecke anpassen und sich so die thermische Belastbarkeit der elektrischen und elektronischen Bauelemente gut einhalten lässt, was wiederum ein hohe Anwendungssicherheit zur folge hat. Die Anwendung des Verfahrens erfordert auch keine überhöhten Pressdrücke bei der Zusammenführung der Bauelemente mit dem Kühlkörper.

Der Ausschluss von Gallium bei der stofflichen Zusammensetzung des erfindungsgemäßen Stoffes erlaubt die Anwendung desselben auch mit Aluminiumwerkstoffen.

Erfindungsgemäß werden auch keine der Gefahrstoffverordnung unterliegende Metalle oder andere Stoffe verwendet, so dass die Anwendung keinerlei Einschränkungen unterliegt.

## Beschreibung

Die Erfindung betrifft eine Wärmeleitschicht und ein Verfahren zur Herstellung einer haftenden Wärmeleitschicht aus Metall und Metall-Kohlenstoff-Gemischen und Metall gut wärmeleitenden Nichtmetall-Gemischen, insbesondere zur Verwendung in der Elektro- und Elektronikindustrie sowie als Kühlmittel für thermisch hochbelastete mechanische Bauteile z.B. Motoren.

Bekannt ist es, gewisse elektrische und/oder elektronische Bauelemente und Bauteile, z.B. Prozessoren zur Abführung von Prozesswärme mit relativ groß dimensionierten Kühlkörpern aus Metall zu versehen. Die Verbindung wird dabei wegen der Temperaturempfindlichkeit von elektronischen Bauelemente aus kalthärtenden prozesswärmebeständigen Klebstoffen in Form von Wärmeleitpasten oder Wärmeleitpads hergestellt. Eine solche Klebeverbindung ist zwar rationell herstellbar, beeinträchtigt jedoch auch bei minimaler Schichtdicke bzw. Filmdicke wegen geringer Wärmeleitfähigkeit des Klebstoffes den Wärmeübergang erheblich. Dies ist besonders bei modernen elektronischen Hochleistungsbauteilen von Nachteil und erfordert eine unerwünschte und oftmals kaum realisierbare Vergrößerung der Wärmeübergangsflächen an solchen Bauelementen und Bauteilen.

Bekannt sind als Verbindungswerkstoffe auch härtbare Wärmeleitpasten aus einem pastösen Matrixmaterial, welches zur Verbesserung der Wärmeleitfähigkeit Metall- und/oder Graphitpulver und/oder Metalloxyde enthält. Das Matrixmaterial ist ein Silikon oder ein anderer nichtmetallischer Stoff.
Auch diese Wärmeleitpasten haben nur einen unwesentlich verbesserten Wärmeleitwert von etwa 0,5 W/mK bis nicht mehr als 10 W/mK.

Bekannt sind auch metallische Matrixmaterialien aus Gallium oder Legierungen des Galliums insbesondere mit Indium, Zink und Zinn, mit ausreichend guten Wärmeleiteigenschaften, wobei auch noch andere gut wärmeleitende und sich nicht legierende Stoffe, wie z. B. Metallpulver, Kohlenstoff in der Legierung suspendiert sein können.
Nachteilig ist daran, dass sich diese Gallium enthaltenen Wärmeleitpasten sehr stark korrosiv gegen Leichtmetalle, insbesondere gegen Aluminium verhalten. So wird Aluminium von dem Gallium anlegiert,
wobei die so entstandene Gallium-Aluminium-Legierung gegen Luftfeuchtigkeit nicht beständig ist und deren Zersetzungsprodukte bzw. deren Salze wiederum aggressiv auf andere Materialien wirken, weshalb Gallium und Galliumlegierungen der Gefahrstoffverordnung unterliegen, woraus sich unakzeptable Einschränkungen bei der Verwendung solcher Stoffe ergeben. Auch kann der bei der Zersetzung entstehende Wasserstoff im Falle seiner Anreicherung zur Bildung von entzündlichen Wasserstoff-Luftgemischen beitragen (EP 0 44 268 A1). Sie sind deshalb zum Auftrag auf das in der Technik sehr häufig verwendete Aluminium völlig ungeeignet. Nachteilig ist auch, dass solche Wärmeleitpasten der deutschen Gefahrenstoffverordnung.

Bekannt sind weiterhin Wärmeleitfolien in Form von Wärmeleitpads aus thermoplastischer Folie mit einem geringen Wärmeleitwert von nicht mehr als 10 W/mK.

Bekannt sind auch Wärmeleitfolien aus Metall, wie Kupfer, Silber, oder Gold.
Dabei hat es sich erwiesen, dass damit keine Verbesserung des Wärmeübergangs realisierbar ist. Ursächlich ist dafür, dass die festen Metalloberflächen sowohl die des zukühlenden elektrischen oder elektronischen Bauelements als auch die des Kühlkörpers und auch die der Metallfolie mikroskopisch kleine Unebenheiten bzw. eine solche Oberflächenrauhigkeit aufweisen, in denen sich wärmeisolierende Lufteinschlüssen bilden, welche in ihrer Summe eher einen schlechteren Wärmeleitwert bilden als die anderen bekannten nichtmetallischen Wärmeleitstoffe, wobei diese wärmeisolierenden Lufteinschlüsse gleich beiderseitig der Folie vorhanden sind.
Die Möglichkeit, eine relativ weiche Indiumfolie zwischen Bauelement und Kühlkörper zu pressen erfordert einen hohen technologischen Aufwand.
Die meisten elektrischen und elektronischen Bauelemente eignen sich auch nicht für eine solch hohe Druckbeaufschlagung.

Bekannt ist es auch, Wärmeleitschichten als Lötverbindung zu realisieren, was jedoch für den erfindungsgemäßen Anwendungszweck an hochempfindlichen elektrischen und elektronischen Bauteilen nicht in Betracht kommt.

Aufgabe der Erfindung ist es, einen geeigneten Stoff zur Realisierung einer haftenden, frei von Lufteinschlüssen und gut wärmeleitfähigen Verbindung zwischen elektrischen und/oder elektronischen Bauteilen und Bauelementen und Kühlkörpern oder Kühlvorrichtungen, sowie ein Verfahren zur rationellen Herstellung solcher Verbindungen unter Vermeidung der bekannten Nachteile zu schaffen.

Erfindungsgemäß wird die Aufgabe wie mit den Ansprüchen angegeben gelöst.
Die Wärmeleitschicht zur Anordnung zwischen elektrischen und/oder elektronischen und/oder mechanischen Bauelementen und/oder Baugruppen besteht dabei aus einem Wärmeleitstoff mit
a) einer ersten Komponente, wobei diese aus einer metallischen Legierung von 2 bis 98 Gewichtanteilen Indium und 2 bis 98 Gewichtanteilen anderer geeigneter Legierungsmetalle, die mit dem Indium einen Schmelzpunkt zwischen 40 und 100° c aufweisen, wie unter anderen Wismut, und/oder Zinn und unter Ausschluss von solchen Metallen die der deutschen Gefahrstoffverordnung unterliegen, wie unter anderen Gallium, Cadmium, Blei, Quecksilber oder aus
b) aus der ersten Komponente und einer weiteren zweiten Komponente, wobei diese zweite Komponente aus einer metallischen Legierung von 2 bis 98 Gewichtanteilen Indium und 2 bis 98 Gewichtanteilen anderer geeigneter Legierungsmetalle, die mit dem Indium einen Schmelzpunkt zwischen 40 und 100° c aufweisen, wie unter anderen Wismut, und/oder Zinn und unter Ausschluss von solchen Metallen die der deutschen Gefahrstoffverordnung unterliegen, wie unter anderen Gallium, Cadmium, Blei, Quecksilber gemäß a), wobei die Legierung noch weitere nicht damit legierende Stoffe wie unter anderen Kohlenstoff in Form von Graphit in fein verteilter Form enthält, die den Schmelzpunkt der Legierung nicht verändern (siehe auch Beispiel 1)
   oder aus
c) zwei oder mehreren Komponenten, welche unmittelbar vor oder während des Auftrages miteinander vermischt werden, wobei mindestens eine Komponente eine solche wie unter a) oder unter b) beschrieben, ist und die andere Komponente oder die anderen Komponenten Metalle enthält, welche sich nach dem Schmelzen der in der ersten Komponente enthaltenen Metalle nach einer gewissen Reaktionszeit, während welcher der Auftrag derselben erfolgt mit diesen zu einer Legierung mit höherer Schmelztemperatur legieren (siehe Beispiel 3)
   oder aus
d) zwei oder mehrerer Komponenten die miteinander vermischt werden, wobei mindestens eine Komponente eine solche wie unter a) oder unter b) beschrieben, ist und wobei die andere Komponente oder die anderen Komponenten Metalle enthält, welche sich nach dem Schmelzen der in der ersten Komponente enthaltenen Metalle mit diesen zu einer Legierung mit höherer Schmelztemperatur als die der ersten Komponente in einer gewissen Zeitspanne legieren, wobei unmittelbar nach Einbringen der zweiten Komponente in die Schmelze der ersten Komponente das Gemisch auf eine Temperatur unterhalb des Schmelzpunktes der ersten niedrigschmelzenden Komponente abgekühlt wird, womit es zunächst bei einem Gemisch bleibt und keine Legierung der beiden Komponenten erfolgt und erst bei erneuter länger andauernder Erwärmung über den Schmelzpunkt der ersten Komponente hinaus es zu einer Legierung beider Komponenten als einer irreversiblen Reaktion kommt (seihe auch Beispiel 4)
   oder aus
e) einer dünnen Folie des Stoffes der ersten Komponente, wie unter a) und b) beschrieben und einer dünnen Folie aus einem sich mit der ersten Komponente leicht legierenden Metall, wie z.B. Magnesium, die zunächst zu einer doppellagigen Folie zusammen gefügt und sodann zwischen Bauelement und Kühlkörper platziert werden und sodann solange über den Schmelzpunkt der ersten Legierung hinaus erwärmt werden bis beide Folien miteinander legiert sind,
wobei der Schmelzpunkt der Legierung ansteigt und dieselbe aushärtet und die so entstandene Legierung mit dem Bauelement und dem Kühlkörper verschmolzen sind ( siehe auch Beispiel 5).

Zur Herstellung der Wärmeleitschicht zwischen elektrischen und/oder elektronischen Bauelementen und/oder Baugruppen und Kühlkörpern und/oder Kühlelementen wird zunächst, ein erfindungsgemäßer Wärmeleitstoff auf die zu kühlenden Wärmeleitflächen des elektrischen und/oder elektronischen Bauelementes und/oder dem Kühlkörper oder dem Kühlelement aufgetragen, was durch Auflegen von fester Wärmeleitfolie oder durch Streichen, Spritzen, Gießen, oder Drucken von flüssigen oder pastösen Beschichtungen erfolgt. Sodann werden die so beschichteten Flächen, sich berührend zusammengebracht.
Wurde der aufgetragene Stoff in fester Form oder in pastöser Form z.B. als Folie, als Pulver oder Paste aufgetragen, dann muss er während des Auftrages oder nach dem Auftrag auf eine Temperatur erwärmt werden, die über der Schmelztemperatur der in der ersten Komponente, wie unter a) und b) beschrieben, enthaltenen Metalllegierung liegt. Solch ein als Folie, Pad, Pulver, Flüssigkeit(Suspension) konfektionierter Wärmleitstoff wird als Wärmeleitschicht zwischen die zu beschichtenden Flächen der elektrischen und/oder elektronischern und/oder mechanischen Bauelemente und dem Kühlkörper und/oder dem Kühlsystem ,diese berührend, platziert und sodann durch Zuführung von Wärme auf eine Temperatur erwärmt, die über der Schmelztemperatur der sich in der ersten Komponente nach a) und b) befindenden Metalllegierung liegt.
Das Aufschmelzen des Wärmeleitschicht erfolgt so, dass der Wärmeleitstoff vor oder während des Auftrages durch Zuführung externer Wärme geschmolzen und auf eine oder beide Flächen zwischen denen die Wärmeleitung stattfinden soll, aufgetragen wird und die Flächen zusammengeführt werden (siehe auch Beispiel 6)
oder der Wärmeleitstoff wird ungeschmolzen auf eine oder beide der Flächen platziert, zwischen denen der Wärmetransport erfolgen soll. Kurzzeitig vor, während oder nach dem Zusammenführen der beschichteten Flächen wird durch externe Erwärmung derselben, der Wärmeleitstoff ganz oder teilweise geschmolzen, was mittels eines Heißluftstromes oder in einem Wärmetunnel oder durch eine direkte Berührung des Kühlkörpers mit einem beheizten Passstück erfolgen kann. Die Schmelzwärmezufuhr kann auch durch die kurzzeitige Inbetriebnahme des zu kühlenden Bauelements mit maximaler Leistung erfolgen, indem die Verlustwärme desselben den vorher aufgetragenen Wärmeleitstoff ganz oder teilweise zum Schmelzen bringt.

Die Vorzüge der Erfindung bestehen darin, dass eine mittels des erfindungsgemäßen Wärmeleitstoffes hergestellte Wärmeleitschicht ausschließlich aus sehr gut wärmeleitenden Materialien besteht.
Die erfindungsgemäß hergestellte Wärmeleitschicht ist während des Auftrages oder nach dem Auftrag zeitweilig flüssig oder pastös. Sie passt sich dadurch den Oberflächen optimal an. Den Wärmeübergang störende und behindernde isolierend wirkende Lufteinschlüsse sind so weitgehend vermieden.
Durch die verschiedenen Konfektionierungen als Paste, Folie, Flüssigkeit oder Barren für eine Schmelze ist der technologische Prozess für die Anwendung der Erfindung sehr variabel.
Auch der erfindungsgemäße Wärmeleitstoff selbst lässt sich durch die Auswahl seiner Legierungsbestandteile genau definiert den erforderlichen und gewünschten unterschiedlichen Schmelztemperaturen für unterschiedliche Anwendungszwecke anpassen. Es lässt sich so die thermische Belastbarkeit der elektrischen und elektronischen Bauelemente gut einhalten, was wiederum ein hohe Anwendungssicherheit zur Folge hat.

Die Anwendung des Verfahrens erfordert auch keine überhöhten Pressdrücke bei der Zusammenführung der Bauelemente mit dem Kühlkörper.
Der Ausschluss von Gallium bei der stofflichen Zusammensetzung des erfindungsgemäßen Wärmeleitstoffes erlaubt die Anwendung desselben auch mit Aluminiumwerkstoffen.
Erfindungsgemäß werden auch keine der deutschen Gefahrstoffverordnung unterliegende Metalle oder andere Stoffe verwendet, so dass die Anwendung keinerlei Einschränkungen unterliegt.
Die thermische Belastbarkeit des erfindungsgemäßen Wärmeleitstoffes ist sehr hoch. Er ist bei tiefer Temperatur und bei einer Temperatur von mehr als 1000°C verwendbar.

Nachstehend wird die Erfindung an mehreren Ausführungsbeispielen erläutert.

### Beispiel 1

Zur Herstellung eines Wärmeleitstoffes für eine Wärmeleitschicht werden Indium, Wismut, Zinn geschmolzen und miteinander legiert sowie die Legierung mit Graphitpulver angereichert.

### Beispiel 2

Eine bei 70° C schmelzende Legierung aus Indium, Wismut und Zinn und darin enthaltenem Graphit wird pulverisiert und mit Wasser zu einer Paste verrührt. Diese Paste wird auf die Kontaktfläche eines zu kühlenden elektronischen Bauelementes aufgetragen und der Kühlkörper aufgesetzt. Das elektronische Bauelement wird sodann kurzzeitig unter maximale Betriebsspannung gesetzt, sodass sich Verlustwärme entwickelt, welche das Wasser verdunstet und die Legierung schmilzt. Nach Abkühlung auf Normaltemperatur verbleibt die so entstandene Wärmeleitschicht haftend zwischen Bauelement und Kühlkörper.

### Beispiel 3

Magnesiumpulver wird in eine flüssige niedrigschmelzende metallische Legierung (Schmelze), bestehend aus Indium, Wismut und Zinn, eingerührt. Die so entstandene Paste wird auf die zu beschichtenden Oberflächen aufgetragen und diese werden dann zusammengeführt. Erst nach einer gewissen Zeit legiert sich das eingebrachte Magnesium vollständig oder teilweise, wodurch die Schmelztemperatur ansteigt und die Wärmeleitschicht damit aushärtet.

### Beispiel 4

Magnesiumpulver wird in eine flüssige, niedrigschmelzende metallische Legierung, bestehend aus Indium, Wismut und Zinn eingerührt. Die dabei entstehende Paste wird in einer Form schnell abgekühlt, so dass sich diese noch vor einer Legierungsbildung mit der Schmelze verfestigt.
Das so hergestellte Formteil aus Wärmeleitstoff wird zu Folie ausgewalzt. Diese Folie wird sodann als Flächenformteil oder als daraus hergestelltem Pad zwischen die zu verbindenden Oberflächen platziert. Erst nach anschließender Erwärmung legiert das Magnesium vollständig mit den übrigen Legierungsbestandteilen zu einer Legierung neuer Qualität mit höheren Schmelzpunkt als die Indium-Wismut- Zinn- Legierung und härtet dauerhaft aus.

### Beispiel 5

Eine doppellagige Wärmeleitfolie aus einer ersten Lage bei 59°C schmelzenden Indium- Wismut- ZinnLegierung mit darin befindlichen anderen nichtmetallischen Stoffen wie Graphit und einer zweiten Lage Magnesiumfolie wird zwischen die Wärmeleitflächen, diese berührend, platziert und erwärmt. Nach einer gewissen Reaktionszeit legieren beide Lagen zu einer Wärmeleitschicht mit höherem Schmelzpunkt als die Indium- Wismut- Zinn- Legierung allein und die Wärmeleitschicht härtet unreversibel aus.

### Beispiel 6

Der Wärmeleitstoff wird in einem Behälter auf Schmelztemperatur erwärmt und die Schmelze dann mittels eines Pinsels auf die Wärmeleitflächen aufgetragen.

### Beispiel 7

Eine Wärmeleitstoff-Folie wird zwischen die zu verbindenden Wärmeleitflächen, diese berührend platziert und zusammengedrückt. Sodann wird die Wärmeleitschicht-Folie auf eine Temperatur minimal über der Schmelztemperatur der niedrigstschmelzenden Komponente erwärmt.

### Beispiel 8

Eine Wärmeleitstoff-Folie wird zwischen die zu verbindenden Wärmeleitflächen, diese berührend platziert und zusammengedrückt. Bei erstmaliger Inbetriebnahme mit maximaler Leistungsaufnahme des so aus Bauelementen und Kühlkörpern zusammengesetzten Bauteiles erfolgt eine Erwärmung der Wärmeleitstoff-Folie auf eine Schmelztemperatur höher als die der Legierung der Wärmeleitstoff-Folie, wobei eine haftenden Wärmeleitschicht entsteht.

## Patentansprüche

1. Wärmeleitschicht zur Anordnung zwischen elektrischen und/oder elektronischen mechanischen Bauelementen und/oder Baugruppen einerseits und Kühlkörpern und/oder Kühlelementen andererseits,
**dadurch gekennzeichnet,**
**dass** deren stoffliche Zusammensetzung einer bei 20° C festen, aber unter 100° C ganz oder teilweise flüssigen Metalllegierung besteht,
wobei dieser Wärmeleitstoff als alleinige oder als eine erste Komponente etwa 2 bis 98 Gewichtsanteile Indium und 2 bis 98 Gewichtsanteile anderer geeigneter Metalle, wie unter anderen Zinn und/oder Wismut und/oder Zink und/oder Kupfer und/oder Silber, mit Ausnahme von Gallium in relevanten Mengen, jeweils allein oder im Gemisch mit einem oder mehreren dieser Stoffe enthält
oder
wobei darin andere weitere gut wärmeleitfähige, sich damit nicht oder nur schwer legierende Stoffe, wie Graphit, Kupfer, Silber Wolfram, Molybdän und und/oder andere geeignete gut wärmeleitende nichtmetallische Stoffe, wie Kohlenstoff in Form von Graphit, allein oder im Gemisch mit einem oder mehreren dieser Stoffe enthält,
wobei die nicht oder die nur schwer legierenden Stoffe in der Wärmeleitschicht in fein verteilter Form darin suspendiert sind
oder
wobei der Wärmeleitstoff jeweils allein oder anteilig als eine zweite Komponente weitere Gewichtsanteile von Stoffen wie unter anderen Magnesium, mit Ausnahme von Gallium in relevanten Mengen, allein oder im Gemisch mit einem oder mehreren dieser Stoffe enthält,

2. Wärmeleitschicht nach den Ansprüchen 1 und 2,
**dadurch gekennzeichnet,**
**dass** der Wärmeleitstoff derselben als Halbzeug in Form
- einer Folie und/oder daraus hergestelltem Pad, oder
- einer mehrlagigen Folie aus den unterschiedlichen Wärmeleitstoffkomponenten und/oder daraus hergestelltem Pad oder
- einer mehrlagigen Folie aus den unterschiedlichen Wärmeleitstoffkomponenten beidseitig auf einer Trägerfolie aus Metall und/oder daraus hergestelltem Pad oder
- einer bei Normaltemperatur flüssigen Schmelze als Flüssigkeit oder
- einer Paste des pulverisierten Stoffes mit sich rückstandsfrei verflüchtigenden Netzmittel oder
- eines Barren
oder
- von Pulver
konfektioniert ist.

3. Verfahren zur Herstellung der Wärmeleitschicht nach den Ansprüchen 1 und 2, **dadurch gekennzeichnet,**
**dass** ein als Barren konfektionierter Stoff zunächst zur Schmelze gebracht wird und die Schmelze sodann durch Streichen, Spritzen, Sprühen, Tauchen oder Drucken auf die Wärmeleitflächen der Bauelemente und/oder Bauteile einseitig oder beidseitig aufgetragen wird, die Wärmeleitflächen der Bauelemente und Bauteile zusammengeführt werden und sodann angekühlt werden oder
**dass** ein als Folie oder Pad oder Paste oder Pulver oder als Flüssigkeit konfektionierter Stoff zunächst zwischen die Wärmeleitflächen der Bauelemente und Bauteile, diese berührend platziert wird und sodann durch externe Wärmezufuhr mittels Heißluftstrom, Wärmetunnel oder Strahlungswärme erwärmt wird, womit der Stoff in Schmelze gelangt und nach Abkühlung damit die Wärmeleitschicht ausbildet
oder
**dass** ein als Paste konfektionierter Wärmeleitstoff zunächst auf mindesten einer der Wärmeleitflächen aufgetragen wird, sodann erwärmt wird bis sich das Netzmittel aus der Paste verflüchtigt hat, sodann die Wärmeleitflächen sich berührend zusammengebracht werden und der Wärmeleitstoff weiter durch externe Wärmezufuhr zur Schmelze gebracht wird womit sich die Wärmeleitschicht ausbildet
oder
**dass** der Wärmeleitstoff auf mindestens einer der Wärmeleitflächen der Bauelemente und Bauteile aufgetragen wird, sodann durch externe Wärmezufuhr mittels Heißluftstrom, Wärmetunnel oder Strahlungswärme erwärmt wird, womit der aufgetragen Wärmeleitstoff in Schmelze gelangt und sodann die Wärmeleitflächen zusammengeführt werden und sich nach Abkühlung damit die Wärmeleitschicht ausbildet
oder
**dass** der Wärmeleitstoff auf und zwischen den Wärmeleitflächen platziert wird, sodann die Wärmeleitflächen sich berührend zusammengeführt werden und sodann durch Erzeugung einer maximalen Betriebswärme der Bauelemente und/oder Bauteile den so platzierten Wärmeleitstoff zur Schmelze bringen womit sich nach Abkühlung derselben die Wärmeleitschicht ausgebildet.

4. Verfahren zur Herstellung der Wärmeleitschicht nach Anspruch 1, **dadurch gekennzeichnet, dass** zunächst ein Wärmeleitstoff der ersten Komponente mit niedriger Schmelztemperatur auf die Wärmeleitflächen aufgebracht wird und sodann unmittelbar vor oder während der Herstellung der Wärmeleitschicht die zweite Komponente mit einer höheren Schmelztemperatur als die der ersten Komponente hinzugegeben wird,
wobei in einer Zeitreaktion die Legierung des Wärmeleitstoffes eine höhere Schmelztemperatur als die der ersten Komponente annimmt.

5. Verfahren zur Herstellung der Wärmeleitschicht aus einem Wärmeleitstoff nach Anspruch 1, **dadurch gekennzeichnet, dass** zunächst in einem ersten Verfahrenschritt die Schmelze eines Wärmeleitstoffes der ersten Komponente mit niedriger Schmelztemperatur mit einem Wärmeleitstoff der zweiten Komponente mit höherer Schmelztemperatur schnell zusammengeführt und schnell auf eine Temperatur unterhalb der Schmelztemperatur der ersten Komponente abgekühlt wird, um so vorerst eine Legierungsbildung in Zeitreaktion mit einer höheren Schmelztemperatur zu vermeiden und um dann in einem zweiten Verfahrensschritt daraus die Wärmeleitschicht herzustellen.
